(19) **Europäisches Patentamt**
**European Patent Office**
**Office européen des brevets**

(11) **EP 1 402 423 B1**

(12) **EUROPÄISCHE PATENTSCHRIFT**

(45) Veröffentlichungstag und Bekanntmachung des Hinweises auf die Patenterteilung:
**02.06.2010 Patentblatt 2010/22**

(21) Anmeldenummer: **01986842.1**

(22) Anmeldetag: **28.12.2001**

(51) Int Cl.:
**G06F 17/50** (2006.01)

(86) Internationale Anmeldenummer:
**PCT/DE2001/004957**

(87) Internationale Veröffentlichungsnummer:
**WO 2002/056208 (18.07.2002 Gazette 2002/29)**

(54) **VERFAHREN ZUR BESTIMMUNG DES KRITISCHEN PFADES EINER INTEGRIERTEN SCHALTUNG**

METHOD FOR DETERMINING THE CRITICAL PATH OF AN INTEGRATED CIRCUIT

PROCEDE DE DETERMINATION DU CHEMIN CRITIQUE D'UN CIRCUIT INTEGRE

(84) Benannte Vertragsstaaten:
**DE FR GB IT**

(30) Priorität: **15.01.2001 DE 10101540**

(43) Veröffentlichungstag der Anmeldung:
**31.03.2004 Patentblatt 2004/14**

(73) Patentinhaber: **Infineon Technologies AG 85579 Neubiberg (DE)**

(72) Erfinder:
• **BERTHOLD, Jörg**
**81675 München (DE)**
• **LORCH, Henning**
**81541 München (DE)**
• **EISELE, Martin**
**81547 München (DE)**

(74) Vertreter: **Lange, Thomas**
**Patentanwälte**
**Lambsdorff & Lange**
**Dingolfinger Strasse 6**
**81673 München (DE)**

(56) Entgegenhaltungen:
• **EISELE M ET AL: "The impact of intra-die device parameter variations on path delays and on the design for yield of low voltage digital circuits" 1996 INTERNATIONAL SYMPOSIUM ON LOW POWER ELECTRONICS AND DESIGN, MONTEREY, CA, USA, 12-14 AUG. 1996, Bd. 5, Nr. 4, Seiten 360-368, XP002243764 IEEE Trans. Very Large Scale Integr. (VLSI) Syst. (USA), IEEE Transactions on Very Large Scale Integration (VLSI) Systems, Dec. 1997, IEEE, USA ISSN: 1063-8210**
• **BOWMAN K A ET AL: "Impact of extrinsic and intrinsic parameter fluctuations on CMOS circuit performance" IEEE JOURNAL OF SOLID-STATE CIRCUITS, AUG. 2000, IEEE, USA, Bd. 35, Nr. 8, Seiten 1186-1193, XP002243765 ISSN: 0018-9200**

**Beschreibung**

Die Erfindung betrifft ein Verfahren zum Bestimmen eines oder mehrerer kritischer Pfade einer integrierten Schaltung.

Kritische (Signal-)Pfade sind diejenigen Pfade einer integrierten Schaltung, welche die Signalverarbeitungsgeschwindigkeit der Schaltung und damit ihre Leistungsfähigkeit begrenzen. Soll die Leistungsfähigkeit der Schaltung gesteigert werden, muß zunächst der kritische Pfad ermittelt und dann durch Optimierung beschleunigt werden. Letzteres kann dadurch erfolgen, daß die Signallaufzeit dieses Pfades durch stärkere Transistoren oder Gatter verkürzt wird.

Üblicherweise wird davon ausgegangen, daß in einer integrierten Schaltung der kritische Pfad durch den "längsten" Pfad (d.h. den Pfad mit der maximalen Signallaufzeit Tm) bestimmt ist. Ein Ziel der Schaltungsentwicklung ist es daher, diesen längsten Pfad in der Schaltung ausfindig zu machen.

Das konventionelle Vorgehen zum Auffinden des kritischen bzw. längsten Pfads einer Schaltung besteht darin, daß im Verlauf einer Analyse oder Simulation der Schaltung anhand des Schaltungsentwurfs für jeden Pfad festgestellt wird, ob er länger ist als der längste der bis dahin untersuchten Pfade. Wenn er kürzer ist, wird er im folgenden nicht weiter berücksichtigt. Wenn er länger ist, wird er so lange als kritischer Pfad betrachtet, bis gegebenenfalls ein noch längerer Pfad ermittelt wird.

Es ist auch bereits bekannt, für eine integrierte Schaltung mehrere kritische Pfade zu bestimmen. Beispielsweise können sämtliche analysierten Pfade, deren Signallaufzeit in das Intervall mit den Grenzen 0,95 x Tm bis Tm fallen, als kritische (und somit zu optimierende) Pfade definiert werden.

Die vorliegende Erfindung beruht auf der Erkenntnis, daß dieses Verfahren bei modernen CMOS-Technologien nicht mehr anwendbar ist. Dies liegt darin begründet, daß bei modernen CMOS-Technologien die unkorrelierte statistische Schwankung der Transistoreinsatzspannung zunimmt, wobei die Standardabweichung der Verteilung der Einsatzspannung inzwischen bis zu 40mV betragen kann. Dementsprechend schwanken die Gatter- und Pfadlaufzeiten, wobei letztere darüber hinaus von der Anzahl der Gatter in dem betrachteten Pfad abhängen. Diese Gesichtspunkte werden bei dem bekannten Verfahren zur Ermittlung des kritischen Pfades nicht berücksichtigt.

Durch die gegenwärtig in der Technik betriebene Absenkung der Versorgungsspannung wird der beschriebene Effekt (Einfluß der Schwankung der Einsatzspannung auf die Kritizität der Pfade) noch verstärkt. Die Versorgungsspannung beträgt bei einer $0,12\mu\text{m}$-Technologie nur noch etwa 1.2Volt.

In der Veröffentlichung "Impact of Extrinsic and Intrinsic Parameter Fluctuations on CMOS Circuit Performance", K. A. Bowman et al., IEEE Journal of Solid-State Circuits, Band 35, Nr. 8, August 2000, Seiten 1186 - 1193, wird der Einfluß extrinsischer und intrinsischer Parameter-Fluktuationen auf die Ausbeutefunktion des kritischen Pfads betrachtet. Bei Vorhandensein mehrerer kritischer Pfade ergibt sich die Ausbeutefunktion dieser mehreren kritischen Pfade durch Potenzieren der Ausbeutekurve für den einzelnen kritischen Pfad mit der Anzahl der betrachteten Pfade. Eine hohe Anzahl von Pfaden in einer solchen Pfadgruppe kann daher die Wahrscheinlichkeit erhöhen, daß zumindest ein Pfad einer Pfadgruppe im Einsatz der Schaltung eine vorgegebene Signallaufzeit überschreitet.

In der Veröffentlichung "The Impact of Intra-Die Device Parameter Variations on Path Delays and on the Design for Yield of Low Voltage Digital Circuits", M. Eisele, J. Berhold, D. Schmitt-Landsiedel, R. Mahnkopf, IEEE Transactions on Very Large Scale Integration (VLSI) Systems, Band 5, Nr. 4, Dezember 1997, Seiten 360 - 368, wird beschrieben, daß Schaltkreise mit einer hohen Anzahl von kritischen Pfaden und mit einer niedrigen logischen Tiefe am empfindlichsten gegen unkorrelierte Variationen der Gate-Verzögerungszeiten sind. In diesem Zusammenhang ist in der Schrift angegeben, daß die Ausbeutefunktion auch von der Anzahl der kritischen Pfade abhängt und mit zunehmender Anzahl der Pfade in Richtung einer geringeren Ausbeute verschoben wird.

Der Erfindung liegt die Aufgabe zugrunde, ein verbessertes Verfahren für die Bestimmung eines oder mehrerer kritischer Pfade einer integrierten Schaltung anzugeben. Insbesondere soll das Verfahren für Schaltungen mit niedrigen Versorgungsspannungen mit Vorteil einsetzbar sein.

Die der Erfindung zugrunde liegende Aufgabenstellung wird durch die Merkmale des Anspruchs 1 gelöst.

Demzufolge werden zunächst die in der integrierten Schaltung vorgesehenen Pfade, ihre mittleren Pfadlaufzeiten und ihre Pfadlaufzeitschwankungen bestimmt. Die Pfade werden dann nach statistischen Gesichtspunkten geordnet, d.h. Pfade, die im wesentlichen dieselben mittleren Pfadlaufzeiten und dieselben Pfadlaufzeitschwankungen aufweisen, werden zu einem Pfadensemble zusammengefaßt. Zu jedem Pfadensemble wird dann ein Ensemblemaß berechnet, welches die Pfadlaufzeitverteilung dieses Pfadensembles statistisch beschreibt. Die statistische Beschreibung berücksichtigt dabei sowohl, daß ein Pfad in der Regel aus mehreren Gattern besteht, als auch die Tatsache, daß in einem Pfadensemble zumeist mehrere Pfade (mit im wesentlichen identischen statistischen Eigenschaften) enthalten sind. Darüber hinaus wird für die Gesamtheit der betrachteten Pfade ein Maß berechnet, welches als Gesamtmaß bezeichnet wird und welches die Laufzeitverteilung der Gesamtheit der betrachteten Pfade statistisch beschreibt. Zuletzt werden anhand eines Vergleichs der Ensemblemaße bei oder oberhalb einer kritischen Pfadlaufzeit Tc der oder die kritischen Pfade der Schaltung bestimmt. Die Ermittlung der kritischen Pfadlaufzeit Tc erfolgt dabei unter Berücksichtigung des Gesamtmaßes.

Der Begriff "integrierte Schaltung" kann vorliegend sowohl eine integrierte Schaltung in ihrer Gesamtheit (Chip) als auch einen Teilabschnitt einer integrierten Schaltung bezeichnen.

Ein wesentlicher Aspekt der Erfindung besteht somit darin, sowohl die in einem Pfadensemble auftretenden Pfadlaufzeiten als auch die in der gesamten betrachteten Schaltung auftretenden Pfadlaufzeiten statistisch zu beschreiben. Damit werden Pfadlaufzeitschwankungen in den Pfadensemblen und in der gesamten betrachteten Schaltung statistisch erfaßt. Die Bewertung eines Pfads beziehungsweise der Pfade eines Ensembles im Hinblick auf Ihre "Länge" wird - anders als bei den herkömmlichen Verfahren - dann unter Berücksichtigung aller Pfade durchgeführt. Dies kommt dadurch zum Ausdruck, daß die kritische Pfadlaufzeit Tc unter Berücksichtigung des Gesamtmaßes ermittelt wird.

Vorzugsweise wird für die Bestimmung des oder der kritischen Pfade ein Wert für das Gesamtmaß vorgegeben und die kritische Pfadlaufzeit Tc wird als diejenige Pfadlaufzeit ermittelt, bei welcher das Gesamtmaß den vorgegebenen Wert annimmt. Da das Gesamtmaß eine statistische Beschreibung der in der Schaltung auftretenden Pfadlaufzeiten ist, kann der vorgegebene Wert als Konfidenzwert interpretiert werden.

Eine weitere bevorzugte Ausführungsweise des erfindungsgemäßen Verfahrens kennzeichnet sich dadurch, daß als kritische Pfade (nur) diejenigen Pfade bestimmt werden, deren Ensemblemaße bei oder oberhalb der kritischen Pfadlaufzeit einen vorgebbaren Schwellenwert überschreiten. Dadurch wird erreicht, daß von den potentiell kritischen Pfaden (das sind diejenigen Pfade, die bei oder oberhalb der kritischen Pfadlaufzeit ein nicht verschwindendes Ensemblemaß aufweisen) nur die mit einem höheren statistischen Gewicht tatsächlich als kritische Pfade betrachtet werden.

Eine weitere vorteilhafte Maßnahme des erfindungsgemäßen Verfahrens besteht darin, daß nach dem anfänglichen Bestimmen der in der integrierten Schaltung vorgesehenen Pfade und ihrer mittleren Pfadlaufzeiten bereits eine Vorauswahl der im weiteren Verfahrensablauf noch zu berücksichtigenden Pfade vorgenommen wird, derart, daß diejenigen Pfade sogleich verworfen werden, deren mittlere Pfadlaufzeiten kleiner als $\alpha$ x Tm ist, wobei Tm die maximale im vorhergehenden Schritt ermittelte mittlere Pfadlaufzeit ist und $\alpha$ eine Größe kleiner als 1 ist und insbesondere etwa 0,8 betragen kann. Dadurch kann der für die folgenden Verfahrensschritte erforderliche Rechenaufwand deutlich reduziert werden.

Eine vorteilhafte Definition des Ensemblemaßes kennzeichnet sich dadurch, daß dieses durch das Integral über die Summe der Wahrscheinlichkeitsverteilungen der Pfadlaufzeiten der Pfade des betrachteten Pfadensembles von unendlich großen zu kleinen Pfadlaufzeiten gegeben ist. In diesem Fall kann für die Berechnung der Summe der Wahrscheinlichkeitsverteilungen (der Pfadlaufzeiten der Pfade des betrachteten Ensembles) das Produkt aus der Anzahl der Pfade des Pfadensembles und der wahrscheinlichkeitsverteilung eines Pfades dieses Pfadensembles gebildet werden. Bei dieser Näherung werden die Wahrscheinlichkeitsverteilungen sämtlicher Pfade des Pfadensembles als identisch angenommen. Dadurch wird der Rechenaufwand für die Berechnung des Ensemblemaßes reduziert.

Das Gesamtmaß kann beispielsweise durch die Summe der Ensemblemaße gegeben sein.

Es wird darauf hingewiesen, daß das Ensemblemaß und das Gesamtmaß auch auf andere Weise definierte statistische Funktionen sein können. Wesentlich für die Erfindung ist lediglich, daß die Bestimmung der kritischen Pfade durch eine statistische Bewertung der Pfadlaufzeiten sämtlicher relevanten Pfade der Schaltung erfolgt.

Die Erfindung wird nachfolgend anhand eines Ausführungsbeispiels unter Bezugnahme auf die Zeichnung näher erläutert; in dieser zeigt:

Fig. 1    eine schematische Darstellung verschiedener Pfade in einer Schaltung;

Fig. 2    ein Diagramm, in welchem die Wahrscheinlichkeitsverteilung der Pfadlaufzeiten eines Pfads bestehend aus 9 Gattern dargestellt ist;

Fig. 3    ein Diagramm, in welchem die Wahrscheinlichkeitsfunktion (Ausbeute) und die Wahrscheinlichkeitsverteilung der Signallaufzeiten eines Pfads bestehend aus neun Gattern dargestellt sind;

Fig. 4    ein Diagramm, in welchem die Wahrscheinlichkeitsfunktionen (Ausbeuten) der Pfadlaufzeiten eines Pfadensembles bezüglich einer unterschiedlichen Anzahl n von in dem Ensemble enthaltenen Pfaden dargestellt sind;

Fig. 5    ein Diagramm, in welchem die Wahrscheinlichkeitsfunktionen (Ausbeuten) eines Pfades bestehend aus 10 Gattern und eines Pfadensembles bestehend aus 1000 Pfaden mit jeweils 9 Gattern dargestellt sind;

Fig. 6    ein Diagramm, in welchem die Wahrscheinlichkeitsverteilung der Pfadlaufzeiten eines Pfades bestehend aus 10 Gattern und die Häufigkeitsverteilung eines Pfadensembles bestehend aus 1000 Pfaden mit jeweils 9 Gattern dargestellt sind;

Fig. 7    ein Diagramm, in welchem die Integralmaße der in Fig. 6 dargestellten Funktionen sowie die Summe dieser beiden Funktionen dargestellt sind, wobei die Integrationsrichtung von hohen Pfadlaufzeiten zu kleinen Pfadlaufzeiten führt;

und

Fig. 8   einen vergrößerten Ausschnitt des in Fig. 7 gezeigten Diagramms.

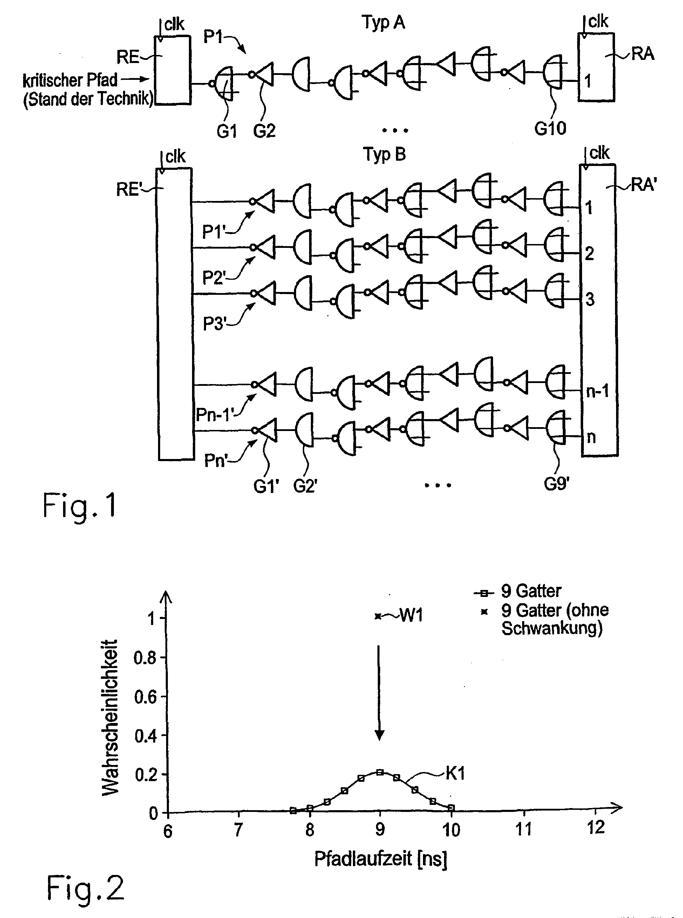

Fig. 1 zeigt in beispielhafter Form eine Schaltung (beziehungsweise einen Schaltungsabschnitt), welche(r) einen Pfad P1 bestehend aus 10 seriell angeordneten Gattern G1, G2, ..., G10 (Typ A) und n identische Pfade P1' P2', ..., Pn' bestehend jeweils aus 9 seriell angeordneten Gattern G1', G2', ..., G9' (Typ B) umfaßt. Die Pfade P1 bzw. P1', ..., Pn' verbinden jeweils getaktete Eingabe- und Ausgaberegister RE, RA bzw. RE' und RA'. Bei dem einzelnen Pfad P1 kann es sich beispielsweise um einen Pfad in einer Steuerungseinheit handeln, während die n identischen Pfade P1'; P2', ..., Pn' typischerweise eine Verarbeitungseinheit wie beispielsweise einen Addierer oder einen Multiplizierer bilden. Beispielsweise weist ein 32 x 32-Multiplizierer bei einer 31-stufigen Pipeline 1024 Pfade der Länge von jeweils 8 Gattern auf. Bei der herkömmlichen Zeitanalyse einer solchen Schaltung zur Ermittlung des kritischen Pfads wird festgestellt, daß der Pfad P1 der längste Pfad ist, da seine Signallaufzeit um eine Gatterlaufzeit länger als die Signallaufzeiten sämtlicher anderer Pfade P1', P2', ..., Pn' ist. Demzufolge würde der Pfad P1 im Stand der Technik als kritischer Pfad identifiziert werden. Soll die Leistungsfähigkeit der Schaltung gesteigert werden, wäre der Pfad P1 durch Optimierung zu beschleunigen.

In dem in Fig. 2 dargestellten Diagramm ist die Wahrscheinlichkeitsverteilung der Pfadlaufzeiten eines der identischen Pfade P1', P2', ..., Pn' vom Typ B bestehend aus 9 Gattern über der Pfadlaufzeit, angegeben in Einheiten von ns, dargestellt. Hervorgerufen durch Schwankungen der Gatterlaufzeit weist die Wahrscheinlichkeitsverteilung (Kurve K1) eine gewisse Breite auf. Würde demgegenüber keine Schwankung der Gatterlaufzeiten auftreten, wäre die Wahrscheinlichkeitsverteilung durch den scharfen Wert W1 = 1 (d.h. 100% Wahrscheinlichkeit) bei einer Pfadlaufzeit von 9ns gegeben.

Die durch die Kurve K1 dargestellte Wahrscheinlichkeitsverteilung ist eine Normalverteilung, welche durch ihren Mittelwert und ihrer Standardabweichung beschrieben wird. Bei dem hier dargestellten Beispiel beträgt der Mittelwert 9ns und die Standardabweichung beträgt 5% des Mittelwertes.

Der Mittelwert und die Standardabweichung der Wahrscheinlichkeitsverteilung K1 lassen sich in bekannter Weise aus den Mittelwerten und Standardabweichungen der einzelnen Gatterlaufzeiten berechnen, welche zu der Pfadlaufzeit beitragen. Der Mittelwert der Wahrscheinlichkeitsverteilung der Pfadlaufzeit ist die Summe der Mittelwerte der Wahrscheinlichkeitsverteilungen der Gatterlaufzeiten und die Standardabweichung der Wahrscheinlichkeitsverteilung der Pfadlaufzeit ist die Wurzel der Summe der quadrierten Standardabweichungen der Verteilungen der Gatterlaufzeit bezüglich der einzelnen Gattern. Wird für sämtliche Gatter eines Pfades eine identische Wahrscheinlichkeitsverteilung für die Gatterlaufzeit vorausgesetzt, ergibt sich

$$\mu_P = N \cdot \mu_G$$

$$\sigma_P = \sqrt{N} \cdot \sigma_G \, ,$$

wobei $\mu_P$ der Mittelwert der Pfadlaufzeit-Verteilung, $\mu_G$ der Mittelwert der Gatterlaufzeit-Verteilung, $\sigma_P$ die Standardabweichung (Streuung) der Pfadlaufzeit-Verteilung und $\sigma_G$ die Standardabweichung der Gatterlaufzeit-Verteilung ist. Mit N wird die Anzahl der Gatter (mit identischer Wahrscheinlichkeitsverteilung) des betrachteten Pfades bezeichnet.

Es wird darauf hingewiesen, daß die einzelnen Gatterlaufzeit-Verteilungen unkorreliert sind. Die Ursache für das Auftreten der Schwankungen liegt in der endlichen Anzahl der bei der Dotierung implantierten Ionen. Nicht betrachtet werden bei dieser Analyse Schwankungen, die auf systematische Effekte (z.B. Änderungen in den Herstellungsbedingungen) zurückzuführen sind und daher korreliert sind.

Die statistischen Größen $\mu_P$ beziehungsweise $\mu_G$ entsprechen der nominellen Pfadlaufzeit beziehungsweise der nominellen Gatterlaufzeit, d.h. denjenigen Laufzeiten, die bei einer definiert vorgegebenen, bei allen Transistoren gleichen Einsatzspannung auftreten würden.

Bei dem in Fig. 2 dargestellten Beispiel beträgt die Standardabweichung der Gatterlaufzeit 15% des Mittelwertes $\mu_G$ der Gatterlaufzeit.

Die in Fig. 2 gezeigte Wahrscheinlichkeitsverteilung kann durch Aufintegrieren in eine Ausbeutekurve umgeformt werden. Die Ausbeutekurve entspricht der Wahrscheinlichkeitsfunktion der Normalverteilung. Die Abszisse gibt jetzt nicht mehr die Pfadlaufzeit an, sondern stellt die Periode des Taktsignals clk dar, mit dem die in Fig. 1 gezeigten Register RE' und RA' getaktet werden. Liegt die Taktperiode bei 9ns, so liegt die Ausbeute bedingt durch die Pfadlaufzeitschwankung lediglich bei 50%. Erst bei längeren Taktperioden von ca. 9.4ns liegt die Ausbeute bei 90%. D.h., wenn das Eingaberegister RE' zu einer Bezugszeit t = 0 an seinem Ausgang vom logischen Zustand 0 zum logischen Zustand 1 wechselt und zum Zeitpunkt t = 9,4ns das Ausgaberegister RA' den logischen Zustand am Ausgang des Pfades P1' ausliest, ist die Wahrscheinlichkeit dafür, daß sich die Zustandsänderungen am Eingang des Pfades P1' mittlerweile am Ausgang bemerkbar gemacht haben, 90%.

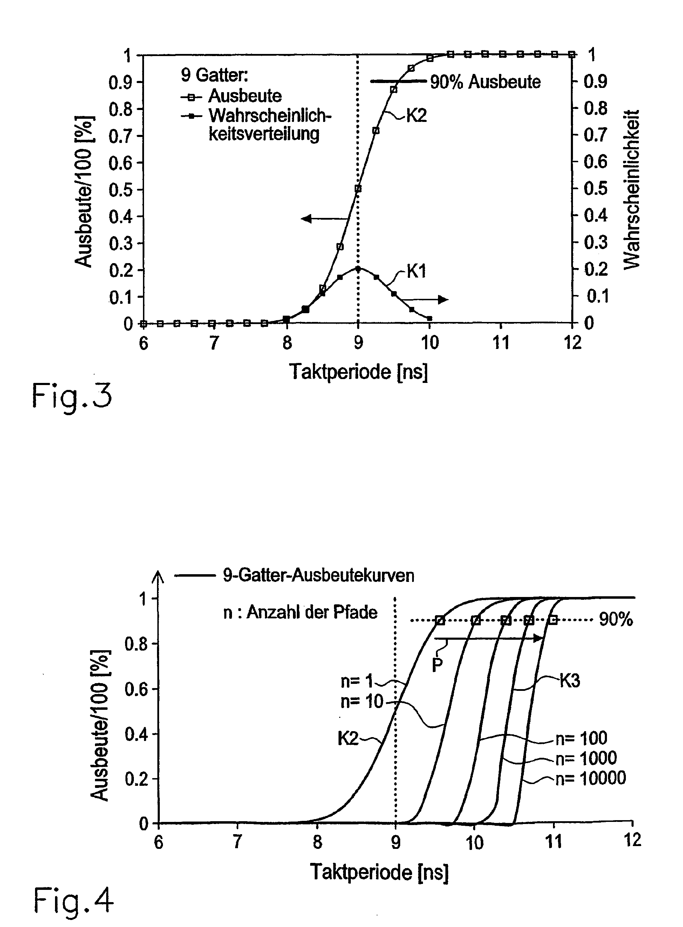

In Fig. 3 bezeichnet K2 die Ausbeutekurve. Sowohl die Ausbeutekurve K2 als auch die Kurve der Wahrscheinlichkeitsverteilung K1 sind gegenüber der Taktperiode (d.h. der Länge des betrachteten Pfads vom Typ B) aufgetragen.

Eine weitere Eigenschaft der (hier betrachteten) Schwankung der Einsatzspannung ist wie bereits erwähnt die fehlende Korrelation, d.h. direkt benachbarte Transistoren können, mit der einer Normalverteilung entsprechenden Wahrscheinlichkeit, Einsatzspannungsunterschiede von bis zu 6 Standardabweichungen aufweisen. Bei einer Standardabweichung von 40mV der Wahrscheinlichkeitsverteilung für die Einsatzspannung entspricht dies einer Differenz von 6 x 40mV = 240mV zwischen den Einsatzspannungen benachbarter Transistoren. Die fehlende Korrelation führt nun dazu, daß die Ausbeutekurve eines Pfades von der Anzahl n der Pfade identischen Aufbaus (d.h. desselben Typs) abhängt.

Pfade identischen Aufbaus werden im folgenden als Pfadensemble bezeichnet (eine breitere Definition dieses Begriffs wird später gegeben). Fig. 4 zeigt die Ausbeutekurven der Pfadensemble vom Typ B mit n = 1, 10, 100, 1000 und 10000. Die Kurve für n = 1 entspricht der Ausbeutekurve K2, d.h. der Ausbeutekurve eines Pfads. Die Ausbeutekurven für n > 1 erhält man durch Potenzieren der Ausbeutekurve K2 mit der Anzahl n der Pfade des Pfadensembles. Fig. 4 zeigt, daß die Taktperiode (d.h. die Länge des Pfadensembles) für ein bestimmtes Ausbeuteniveau, z.B. 90%, dabei zunimmt. Die Zunahme ist in Fig. 4 durch den Pfeil P graphisch veranschaulicht.

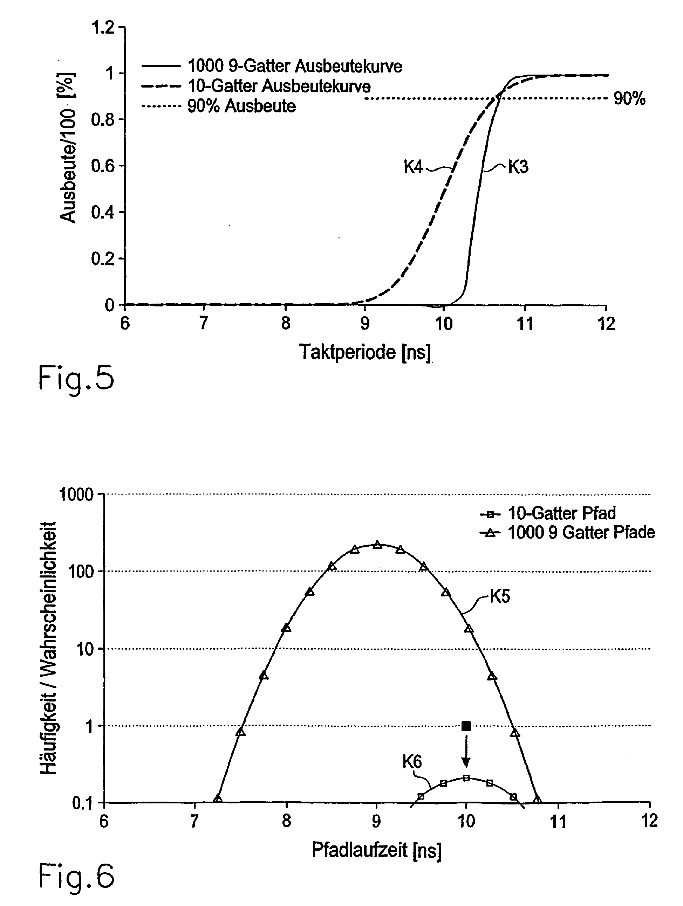

Anhand Fig. 5 wird erläutert, warum bei dem in Fig. 1 dargestellten Schaltungsbeispiel die herkömmliche Ermittlung des kürzesten Pfads unter den genannten Voraussetzungen zu einem falschen Ergebnis hinsichtlich der Ermittlung des kritischen Pfades führt. Die Kurve K3 entspricht der in Fig. 4 gezeigten Ausbeutekurve für n = 1000 Pfaden des Pfadensembles der Pfade vom Typ B. Die Ausbeutekurve des Pfades P1 (allgemeiner: des Pfadensembles der Pfade vom Typ A) ist in Fig. 5 mit K4 bezeichnet. Der Mittelwert der dazugehörigen Wahrscheinlichkeitsverteilung liegt bei einer Taktperiode von 10ns, da er bei einer Ausbeute von 50% auftritt. Fig. 5 macht deutlich, daß bei einer geforderten Ausbeute von 90% die beiden Pfadensemble A und B in etwa gleichgewichtig die Leistungsfähigkeit der Schaltung beeinflussen. Sind mehr Pfade vom Typ B vorhanden oder ist die Schwankung der Gatterlaufzeiten größer (bei diesem Beispiel wurde wie bereits erwähnt eine Gatterlaufzeitschankung von 15% zugrunde gelegt), so wird die Leistungsfähigkeit ausschließlich von den Pfaden des Typs B bestimmt. In diesem Fall müssen also die Pfade P1', ..., Pn' und nicht der Pfad P1 optimiert werden, um das Leistungsverhalten der Schaltung zu verbessern.

Im folgenden wird weiterhin unter Bezugnahme auf das Schaltungsbeispiel in Fig. 1 ein möglicher Ablauf des erfindungsgemäßen Verfahrens erläutert.

Zunächst werden die in der integrierten Schaltung vorgesehenen Pfade und ihre mittleren Pfadlaufzeiten sowie die Standardabweichung der Pfadlaufzeitverteilung bestimmt. Letztere ist wie bereits erwähnt gleich der Wurzel der Summe der quadrierten Gatterlaufzeit-Standardabweichungen.

Nachfolgend können zur Reduzierung des Rechenaufwands diejenigen Pfade, welche die Verarbeitungsgeschwindigkeit der integrierten Schaltung mit Sicherheit nicht begrenzen, verworfen werden. Dies kann beispielsweise dadurch geschehen, daß sämtliche Pfade, deren Pfadlaufzeit kleiner als 0,8 × Tm ist, in den folgenden Verfahrensschritten nicht mehr berücksichtigt werden. Dabei bezeichnet Tm die längste aufgefundene mittlere Pfadlaufzeit, d.h. in dem in Fig. 1 dargestellten Beispiel 10ns des Pfades P1. Da die Pfade des Typs B dieser Bedingung nicht genügen, werden sie nicht verworfen.

Anschließend werden diejenigen Pfade zusammengefasst, deren statistische Kenngrößen übereinstimmen. Zusammengefaßte Pfade bilden ein Pfadensemble. Die einfachste Möglichkeit besteht darin, daß jedes Ensemble ausschließlich aus identischen Pfaden besteht. In Fig. 1 wird ein erstes Pfadensemble durch den Pfad P1 des Typs A gebildet, und ein zweites Pfadensemble wird durch die Pfade P1', P2', ..., Pn' des Typs B geschaffen. Eine allgemeine Definition für ein Ensemble besteht darin, daß die in dem Ensemble enthaltenen Pfade alle im wesentlichen identische mittlere Pfadlaufzeiten und Pfadlaufzeitschwankungen aufweisen, d.h. in Bezug auf ihre statistischen Kenngrößen identisch oder zumindest ähnlich sind.

In einem nächsten Schritt werden die Mittelwerte und Standardabweichungen der Pfadlaufzeiten der Pfadensemble bestimmt. Zur Reduzierung des Rechenaufwands kann die Verteilungsfunktion der n Pfade des Ensembles durch die mit n multiplizierte Verteilungsfunktion (Wahrscheinlichkeitsdichte) eines Pfades dargestellt werden. Dieser Schritt ist in Fig. 6 für das anhand Fig. 1 erläuterte Beispiel veranschaulicht. Durch das Aufsummieren von Verteilungsfunktionen geht man von den Wahrscheinlichkeits-Dichtefunktionen zu einer Häufigkeitsverteilung von Pfadlaufzeiten über, welche auf der logarithmisch eingeteilten Ordinate des in Fig. 6 dargestellten Diagramms aufgetragen ist. Die Kurve K5 ergibt sich durch die Multiplikation der Wahrscheinlichkeits-Dichtefunktion (d.h. der Wahrscheinlichkeitsverteilung) für einen Pfad des Typs B mit n = 1000. Das analoge Vorgehen ergibt für das Ensemble der Pfade des Typs A die Kurve K6, wobei hier n = 1 gilt, da das Ensemble nur einen Pfad, P1, umfaßt (insofern bleibt es hier bei einer Wahrscheinlichkeitsverteilung).

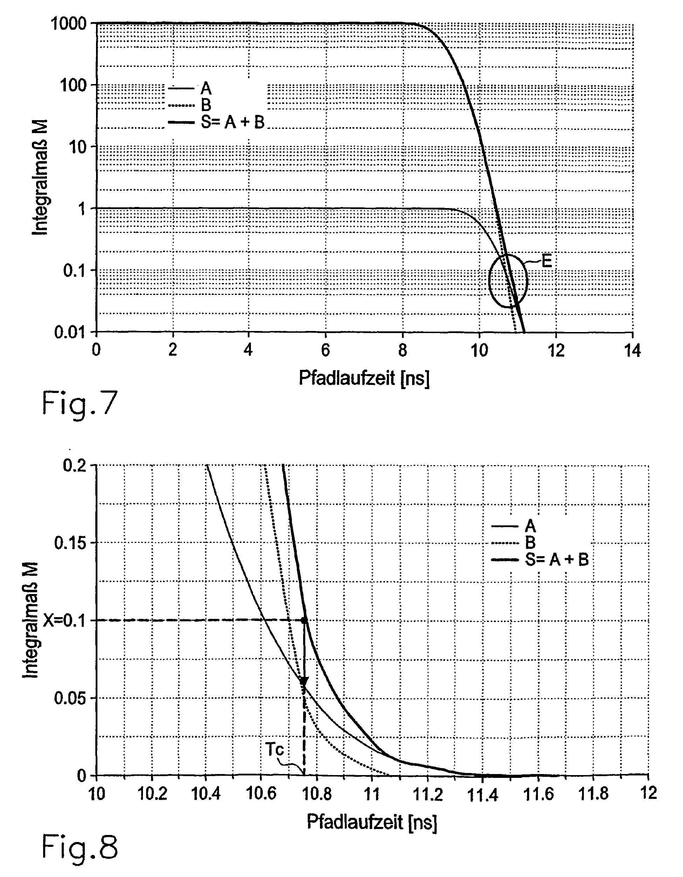

Nachfolgend werden gemäß Fig. 7 die aufsummierten Verteilungsfunktionen (d.h. im allgemeinen Fall die den Ensembles zugeordneten Wahrscheinlichkeitsverteilungen entsprechend K5 und Häufigkeitsverteilungen entsprechend K6) beginnend bei einer Pfadlaufzeit von unendlich großen zu kleinen Pfadlaufzeiten hin aufintegriert. Das dabei erhaltene Integralmaß läßt sich in der Form

$$M(T) = \int_{-\infty}^{\infty} F(T')dT' - \int_{-\infty}^{T} F(T')dT'$$

darstellen, wobei T die Pfadlaufzeit bezeichnet, M(T) das Integralmaß bezeichnet, T' eine Integrationsvariable ist und F(T') die aufsummierte Verteilungsfunktion eines Pfadensembles ist.

In Fig. 7 stellt die gepunktete Linie B das Integralmaß der aufsummierten Verteilung (Kurve K5) der 1000 Pfade des Typs B dar, während die mit einem dünnen Strich durchgezogene Linie A die Verteilung (Kurve K6) des Pfads P1 vom Typ A ist.

In einem weiteren Schritt wird nun die mit einer fetten durchgezogenen Linie dargestellte Kurve S berechnet, welche die Summe der beiden Kurven A und B ist. Die Kurve S repräsentiert das Integralmaß der Gesamtheit aller betrachteten Pfade der der Analyse zugrunde liegenden Schaltung (die Integralmaße sind logarithmisch aufgetragen, der Unterschied zwischen den Kurven S und B ist daher nur bei kleinen Werten des Integralmaßes sichtbar).

Der Additionsschritt zur Ermittlung des Gesamt-Integralmaßes (Kurve S) kann selbstverständlich auch bereits vor der Integration durch Addition der Häufigkeitsverteilungen/ Wahrscheinlichkeitsverteilungen (K5 und K6) erfolgen.

Schließlich werden der oder die kritischen Pfade der Schaltung anhand eines Vergleichs der Integralmaße A und B unter Berücksichtigung des Gesamtmaßes S ermittelt.

Fig. 8 zeigt den Verlauf der Kurven A, B, S innerhalb des in Fig. 7 dargestellten Ausschnitts E in größerer Einzelheit. Zunächst wird eine kritische Taktrate Tc bestimmt, bei der das Gesamtmaß einen Wert x aufweist, wobei x eine der geforderten Ausbeute entsprechende Größe darstellt. Die Beziehung zwischen der Größe x und einer geforderten Ausbeute A (in Prozent) lautet A = (1-x) · 100 [%], d.h. bei einer geforderten Ausbeute von 90% beträgt x = 0,1.

In Fig. 8 ergibt sich für x = 0,1 eine kritische Taktrate Tc = 10,75ns. Dann werden alle Pfade von Pfadensemblen, die in dem Intervall zwischen Tc und T = ∞ zum Gesamt-Integralmaß S beitragen, als kritische Pfade bestimmt.

Aus Fig. 8 ist ersichtlich, daß Pfade des Typs A (Kurve A) und Pfade des Typs B (Kurve B) bei x = 0,1 in etwa gleichermaßen zum Gesamt-Integralmaß S beitragen (der Pfad P1 des Typs A liefert einen Beitrag von etwa 0,055 während der Beitrag der Pfade des Typs B ungefähr 0,045 beträgt).

In einem abschließenden Schritt können diejenigen Pfade, deren Beitrag vergleichsweise gering ist und einen vorgegebenen Grenzwert unterschreitet, aus der Menge der aufgefundenen kritischen Pfade eliminiert werden. Der Grenzwert hängt von der Größe der Schaltung ab. In dem in Fig. 8 dargestellten Beispiel existiert kein derartiger Pfad.

Die beschriebenen Verfahrensschritte werden im Rahmen einer rechnergestützten Analyse oder Simulation der Schaltung auf der Basis eines Schaltungsentwurfes durchgeführt. Der Schaltungsentwurf wird dann in Abhängigkeit von den aufgefundenen kritischen Pfaden optimiert.

**Patentansprüche**

1. Rechnergestütztes Verfahren zum Bestimmen eines oder mehrerer kritischer Pfade einer integrierten Schaltung, welche die Verarbeitungsgeschwindigkeit der integrierten Schaltung begrenzen, mit den Schritten:

   (a) Bestimmen der in der integrierten Schaltung vorgesehenen Pfade (P1; P1', .., Pn'), ihrer mittleren Pfadlaufzeiten und ihrer Pfadlaufzeitschwankungen;
   (b) Ordnen der Pfade (P1; P1', ..., Pn'), wobei Pfade, die im wesentlichen eine identische mittlere Pfadlaufzeit und eine identische Pfadlaufzeitschwankung aufweisen, ein Pfadensemble (A, B) bilden;
   (c) zu jedem Pfadensemble (A, B) Berechnen eines Ensemblemaßes (M), welches die Pfadlaufzeitverteilung dieses Pfadensembles statistisch beschreibt;
   (d) für die Gesamtheit der betrachteten Pfade Berechnen eines Gesamtmaßes, welches die Pfadlaufzeitverteilung der Gesamtheit der betrachteten Pfade statistisch beschreibt;
   (e) Bestimmen des oder der kritischen Pfade der Schaltung anhand eines Vergleichs der Ensemblemaße bei oder oberhalb einer kritischen Pfadlaufzeit Tc, welche unter Berücksichtigung des Gesamtmaßes ermittelt wird.

2. Rechnergestütztes Verfahren nach Anspruch 1, **dadurch gekennzeichnet,**

   - **daß** im Schritt (e) ein Wert für das Gesamtmaß vorgegeben wird und die kritische Pfadlaufzeit Tc als diejenige Pfadlaufzeit ermittelt wird, bei welcher das Gesamtmaß den vorgegebenen Wert annimmt.

3. Rechnergestütztes Verfahren nach Anspruch 1 oder 2, **dadurch gekennzeichnet,**

   - **daß** als kritische Pfade diejenigen Pfade (P1; P1', .., Pn') bestimmt werden, deren Ensemblemaße bei oder oberhalb Tc einen vorgebbaren Schwellenwert überschreiten.

**4.** Rechnergestütztes Verfahren nach einem der vorhergehenden Ansprüche, **dadurch gekennzeichnet, daß** nach Schritt (a) der folgende Schritt eingefügt wird: (a1) Verwerfen derjenigen Pfade (P1; P1', .., Pn'), deren mittlere Pfadlaufzeit kleiner als $\alpha \times$ Tm ist, wobei Tm die maximale im Schritt (a) ermittelte mittlere Pfadlaufzeit ist und $\alpha$ eine Größe kleiner als 1 ist und insbesondere etwa 0,8 beträgt.

**5.** Rechnergestütztes Verfahren nach einem der vorhergehenden Ansprüche, **dadurch gekennzeichnet,**

- **daß** das Ensemblemaß gegeben ist durch das Integral über die Summe der Wahrscheinlichkeitsverteilungen der Pfadlaufzeiten der Pfade des betrachteten Pfadensembles, und
- **daß** für die Berechnung der Summe der Wahrscheinlichkeitsverteilungen das Produkt aus der Anzahl der Pfade des Pfadensembles und der Wahrscheinlichkeitsverteilung eines Pfades des Pfadensembles gebildet wird.

**6.** Rechnergestütztes Verfahren nach einem der vorhergehenden Ansprüche, **dadurch gekennzeichnet,**

- **daß** das Gesamtmaß (S) durch die Summe der Ensemblemaße (A, B) gegeben ist.

**Claims**

**1.** Computer-aided method for determining one or more critical paths of an integrated circuit, which limit the processing speed of the integrated circuit, with the following steps:

a) determining the paths (P1; P1', ..., Pn') provided in the integrated circuit, their mean path transit times and their path transit time fluctuations;
b) ordering the paths (P1; P1', ..., Pn'), where paths having essentially an identical mean path transit time and an identical path transit time fluctuation form a path group (A, B);
c) for each path group (A, B), calculating a group figure (M) which statistically describes the path transit time distribution of this path group;
d) for the totality of the paths considered, calculating a total figure which statistically describes the path transit time distribution of the totality of the paths considered;
e) determining the critical path or paths of the circuit by comparing the group figures at or above a critical path transit time Tc which is determined by taking into consideration the total figure.

**2.** Computer-aided method according to Claim 1, **characterized**

- **in that** in step (e), a value for the total figure is predetermined and the critical path transit time Tc is determined as the path transit time at which the total figure assumes the predetermined value.

**3.** Computer-aided method according to Claim 1 or 2, **characterized**

- **in that** the paths (P1; P1', ..., Pn'), the group figures of which exceed a predeterminable threshold value at or above Tc, are determined as critical paths.

**4.** Computer-aided method according to one of the preceding claims, **characterized in that** after step (a), the following step is inserted:

(al) discarding all those paths (P1; P1', ..., Pn'), the mean path transit time of which is less than $\alpha \times$ Tm, where Tm is the maximum mean path transit time determined in step (a) and $\alpha$ is a quantity of less than 1 and, in particular, is about 0.8.

**5.** Computer-aided method according to one of the preceding claims, **characterized**

- **in that** the group figure is given by the integral over the sum of the probability distributions of the path transit times of the paths of the path group considered, and
- **in that**, for calculating the sum of the probability distributions, the product of the number of paths of the path group and the probability distribution of one path of the path group is formed.

**6.** Computer-aided method according to one of the preceding claims, **characterized**

- **in that** the total figure (S) is given by the sum of the group figures (A, B).

**Revendications**

**1.** Procédé assisté par ordinateur de détermination d'un chemin critique ou de plusieurs chemins critiques d'un circuit intégré, qui limitent la vitesse de traitement du circuit intégré, comprenant les stades dans lesquels :

(a) on détermine les temps de parcours moyens et les fluctuations de temps de parcours des chemins (P1 ; P1', ... , Pn'), prévus dans le circuit intégré ;

(b) on ordonne les chemins (P1 ; P1', ... , Pn'), les chemins qui ont sensiblement un temps de parcours moyen identique et une fluctuation du temps de parcours identique formant un ensemble (A, B) de chemins ;

(c) on calcule pour cet ensemble (A, B) de chemins une grandeur (M) d'ensemble, qui décrit statistiquement la répartition des temps de parcours de chemin de cet ensemble de chemins ;

(d) on calcule, pour la totalité des chemins considérés, une grandeur globale, qui décrit statistiquement la répartition des temps de parcours de la totalité des chemins considérés ;

(e) on détermine le chemin critique ou les chemins critiques du circuit au moyen d'une comparaison des grandeurs d'ensemble pour ou au-dessus d'un temps Tc de critique de parcours, qui est déterminé en tenant compte de la grandeur globale.

2.  Procédé assisté par ordinateur suivant la revendication 1,
    **caractérisé**

    - **en ce que** l'on prescrit au stade ( e ) une valeur de la grandeur globale et on détermine le temps Tc critique de parcours comme le temps de parcours pour lequel la grandeur globale prend la valeur prescrite.

3.  Procédé assisté par ordinateur suivant la revendication 1 ou 2,
    **caractérisé**

    - **en ce que** l'on détermine comme chemins critiques, les chemins (P1 ; P1', ... , Pn') dont les grandeurs d'ensemble dépassent, pour ou au-dessus de Tc, une valeur de seuil pouvant être prescrite.

4.  Procédé assisté par ordinateur suivant l'une des revendications précédentes,
    **caractérisé**

    - **en ce qu'**après le stade (a) on adjoint le stade suivant : (a1) on rejette les chemins (P1 ; P1', ... , Pn') dont le temps de parcours moyen est plus petit que $\alpha$ x Tm, Tm étant le temps de parcours moyen maximum déterminé au stade (a) et $\alpha$ une grandeur plus petite que 1 et, notamment, d'environ 0,8.

5.  Procédé assisté par ordinateur suivant l'une des revendications précédentes,
    **caractérisé**

    - **en ce que** la grandeur d'ensemble est donnée par l'intégrale sur la somme des répartitions de probabilité des temps de parcours de l'ensemble des chemins considéré et,

    - **en ce que**, pour le calcul de la somme des répartitions de probabilité, on forme le produit du nombre des chemins de l'ensemble des chemins et de la répartition de probabilité d'un chemin de l'ensemble des chemins.

6.  Procédé assisté par ordinateur suivant l'une des revendications précédentes,
    **caractérisé**

    - **en ce que** la grandeur (S) globale est donnée par la somme des grandeurs (A, B) d'ensemble.

Fig.1

Fig.2

Fig.3

Fig.4

Fig.5

Fig.6

Fig.7

Fig.8

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- **K. A. Bowman et al.** Impact of Extrinsic and Intrinsic Parameter Fluctuations on CMOS Circuit Performance. *IEEE Journal of Solid-State Circuits,* August 2000, vol. 35 (8), 1186-1193

- **M. Eisele ; J. Berhold ; D. Schmitt-Landsiedel ; R. Mahnkopf.** The Impact of Intra-Die Device Parameter Variations on Path Delays and on the Design for Yield of Low Voltage Digital Circuits. *IEEE Transactions on Very Large Scale Integration (VLSI) Systems,* Dezember 1997, vol. 5 (4), 360-368